# EUROPEAN PATENT APPLICATION

(11) **EP 1 225 643 A1**
(43) Date of publication of application: **24.07.2002**
(21) Application number: 01101429.7
(22) Date of filing: 23.01.2001
(51) Int. Cl.: H01L 33/00, H01L 27/15

(54) **High efficiency unilateral light emitting device and method for fabricating such device**

(71) Applicant: INTERUNIVERSITAIR MICROELEKTRONICA CENTRUM VZW, 3001 Leuven (BE)
(72) Inventor: Windisch, Reiner, 3001 Leuven (BE); Heremans, Paul, 3000 Leuven (BE)
(74) Representative: Bird, William Edward

(57) **Abstract**

A unilateral light emitting device is disclosed comprising a semiconductor body and a reflecting element. The semiconductor body emits radiation from all its surfaces. The emitted light is gathered in a single beam after redirection by a reflecting element. The reflecting element redirects the emitted light alongside the semiconductor body.

## Description

### Field of the invention

The present invention relates to a light emitting device comprising a reflecting surface so as to redirect light emitted from a semiconductor body, thus emitting light in a substantially single direction.

### Background of the invention

Light Emitting Devices (LEDs) are being used nowadays in a broad range of applications. Infrared LEDs for example are used in many communication systems such as remote control systems, or for data exchange between computers and peripheral devices such as keyboards, printers, handheld devices etc. For many applications the external efficiency of the LED, i.e. the external collected amount of light emitted from the device compared to the supply current, must be as high as possible, while the fabrication and packaging process must be simple and cost-effective.

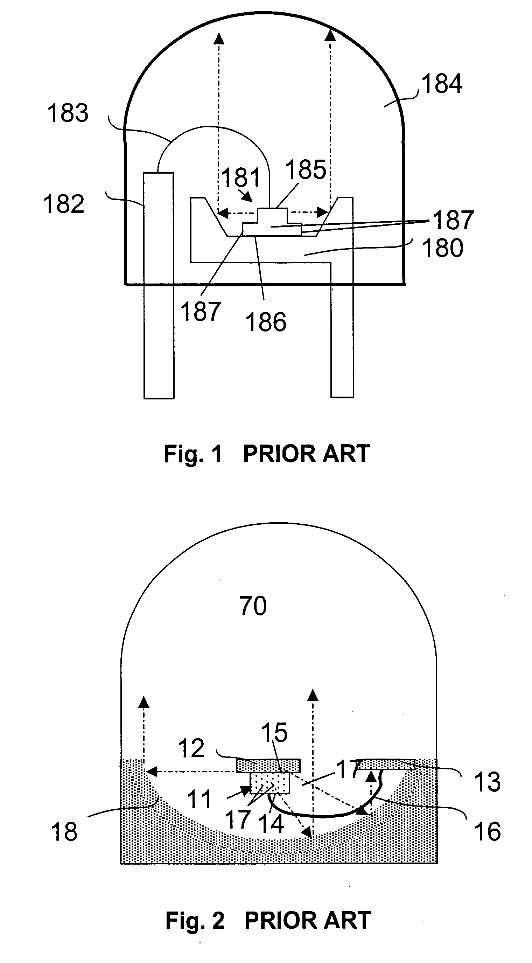

Two types of LEDs can be distinguished. A first type, called lens type LED, directly radiates light from a front surface and e.g. four side surfaces of a light-emitting element to the outside world or the surrounding medium. Such a lens type LED is disclosed in US-5537433, and is represented in Fig. 1. A LED 181 with a front surface 185, a back surface 186 and e.g. four side surfaces 187, is placed with its back surface 186 on top of a heat sink 180, which also provides a backside contact. A contact at the front surface 185 of the LED 181 is connected trough a bonding wire 183 to a lead 182. The whole device is sealed with an optical transparent resin 184 that also serves as lens. The light emitted from the front surface 185 of the LED 181 directly contributes to the front side radiation. Most of the light radiated from the four side surfaces 187 of the LED 181 will first be reflected at the inner surfaces of the heat sink 180, as indicated by the dashed arrows in Fig. 1, before contributing to this front side radiation. Light that is not directly propagating towards the front surface 185 or to the side surfaces 187 of the LED 181, has to be redirected before contributing to the front side radiation. This redirected radiation has to travel through the solid-state LED 181 before reaching the front surface 185, where it can be emitted to a surrounding medium.

This redirection can be done e.g. inside the LED 181 by an internal reflection layer, at the back surface 186 of the LED 181 or by the heat sink 180 having reflecting properties. In US-5537433 such an internal reflection layer is disclosed, making use of the difference in refractive index between subsequent layers present within a LED. In EP-998701619 or US-5486946 reflection at the backside of a LED is obtained by a metallic mirror which is connected to or formed on the back surface of the LED. This backside mirror reflects the radiation towards the front side of the LED, where it contributes to the front side radiation.

A second LED type, called reflection type LED, indirectly radiates light from a front surface and e.g. four side surfaces of a light-emitting element to the outside world or a surrounding medium. In EP-0936683 such a reflection type LED is disclosed. The principles of this type of LED are represented in Fig. 2. To have all the light generated by a LED 11 projected towards a same orientation, i.e. towards the top surface of a housing or package, it is desirable to provide a bowl-shaped reflector having a reflecting surface at the concave side thereof, the reflector being preferably parabolic shaped, to surround the LED die. This type of LED hence requires dedicated packages and packaging techniques in order to obtain the desired shape of the reflecting surface, to place the LED upside down and to connect it.

A LED 11, with a front surface 14, a back surface 15 and e.g. four side surfaces 17, is placed upside down in a focal point of a concave reflection surface 18, i.e. with its back surface 15 towards the top of a housing or package 70, which is the top hemisphere in Fig. 2 which finally sends the light towards a surrounding medium. The front surface 14 is connected to a front side contact 13 by means of a bonding wire 16. The back surface 15 is connected to a lead assembly 12. The dimensions of the LED 11 are small compared to the dimensions of the package in order to have the light generation essentially from this focal point. The reflection surface 18 reflects the light emitted from the four side surfaces 17 and from the front surface 14 so that the reflected light is radiated and directed towards the top of the housing 70. The front side contact 13 limits the propagation of some of the light, thus decreasing the external efficiency of the overall device. Also for the reflection type LED, the light that does not propagate towards the top surface 14 or side surfaces 17 of the LED 11, but propagates towards the back surface 15, has to be redirected, e.g. at the backside 15 of the LED 11 connected to the lead assembly 12, before contributing to the front side radiation. This redirected light has to travel through the solid-state LED 11 before reaching the top surface 14, where it can be emitted to a surrounding medium.

The prior art devices, both the lens type LEDs as illustrated in Fig. 1 and the reflection type LEDs as illustrated in Fig. 2, provide a light emitting diode mounted in a housing or package. The housing of these devices is shaped to guide the light emitted by the semiconductor LED into a single direction. Light emitted from the side surfaces and the front surface of the LED can be redirected without passing trough the semiconductor body. However a part of the light generated in the semiconductor body propagates in a direction opposite to the direction of the light beam of the mounted device. In order to have this light portion contributing to the light emitted by the mounted device, this part of the light is reflected within the semiconductor body or at its surface. This redirected light must travel through the semiconductor body before reaching the top surface, where it can be emitted to the surrounding medium. The external efficiency of these prior art devices is limited by the parasitic absorption of photons within the semiconductor body or at the reflecting surface.

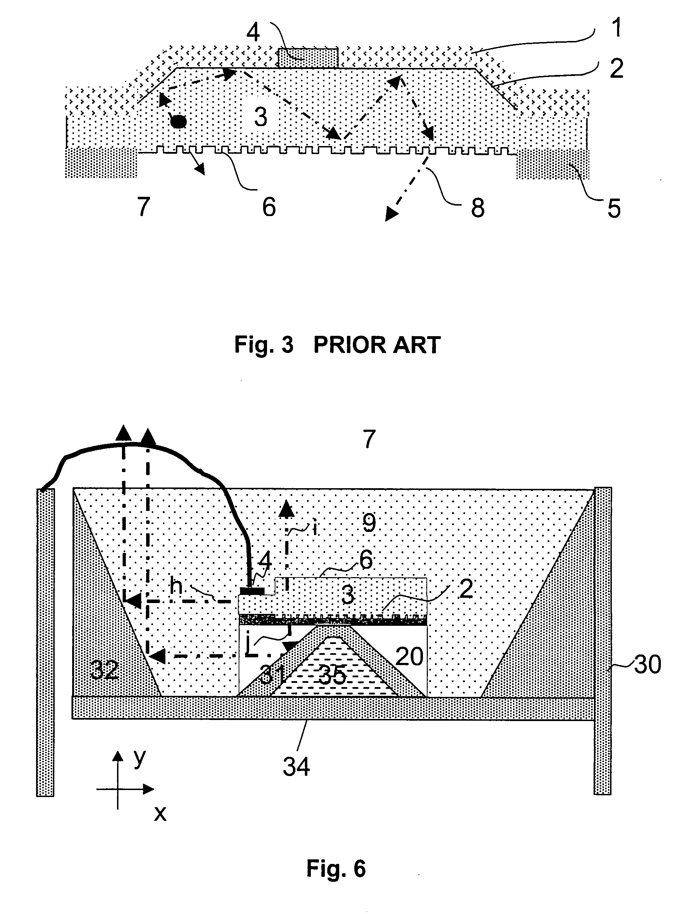

Fig. 3, being an embodiment of EP-998701619, illustrates this phenomenon. A mirror 1 is connected to or formed on a back surface 2 of a semiconductor body 3. Radiation is generated when connecting a front side contact 5 and a back side contact 4 to convenient power supplies. The backside mirror 1 reflects the radiation (photons) generated e.g. within the active layer of a heterojuction within the semiconductor body 3, towards an other main surface of the semiconductor body 3, i.e. the front surface 6. A portion of the reflected photons might suffer total internal reflection at the interface between the front surface 6 of the semiconductor body 3 and the medium surrounding the semiconductor body 3, e.g. air or a sealing resin such as epoxy. These photons are again reflected to the bulk of the semiconductor body 3. Some of the reflected photons can escape and will be radiated by the front surface 6. A portion of the initially backward emitted photons hence bounce in the semiconductor body 3 between the reflecting back surface 2 and the front surface 6 through which they can escape with finite probability. In Fig. 3 the dashed arrow 8 illustrates such a multiple reflected ray, bouncing between front surface 6 and back surface 2, before being outcoupled to the outside world 7. To improve the external efficiency of the LED, the absorption losses of the photons in the semiconductor body 3 can be minimised by reducing the number of passes of photons trough the semiconductor body 3. This can be obtained by texturing the front surface 6 of the semiconductor body 3, as disclosed in EP-998701619 and illustrated in Fig. 3. This textured front surface 6 scatters the photons into different directions, thus offering these photons a new opportunity to escape at the front surface 6 after being reflected again at the above-mentioned backside mirror 1. Hence the probability for the photons to escape from the semiconductor body 3 is the cumulative probability of the escape chance at every pass through the semiconductor body 3, the photons being reflected at the back surface 2 and transmitted or scattered at the textured front surface 6. Despite these improvements one of the main loss mechanisms that still limits the external efficiency of the device remains the absorption of the radiation during each reflection at the backside mirror 1, as the light is not outcoupled at the back surface 2 but is reflected back into the semiconductor body or film 3. At each reflection up to several percent of the incoming radiation is absorbed.

The present invention aims at improving the external efficiency of a light emitting semiconductor device that can be packaged in commercially available packages.

It is a further object of the invention to obtain methods for manufacturing highly efficient light emitting semiconductor devices, that are cost effective and can be applied on wafer scale.

### Summary of the invention

The above objectives are accomplished by the devices and methods according to the present invention.

A light emitting device is disclosed, which comprises a body of semiconductor material emitting radiation in a first direction and in at least one additional direction, of which at least one direction is opposite said first direction, and a reflecting element. The reflecting element is oriented to the body of semiconductor material such that a majority of the radiation emitted by the body of semiconductor material in the opposite direction is redirected alongside the body of semiconductor material by the reflecting element to the first direction. By the redirection alongside the body of semiconductor material is meant that a majority of the redirected radiation bypasses the body of semiconductor material instead of being redirected inside or absorbed by the body of semiconductor material, and thus absorption losses inside the semiconductor material are reduced. By "majority" is meant at least 50%, preferably 60% or more, more preferably 80% or more of the light.

According to a first preferred embodiment of a device according to the present invention, at least a first portion of the reflecting element is formed in an optical transparent substrate supporting the body of semiconductor material.

An inwardly tapered pit is preferably created in the substrate to obtain a reflecting surface. The inwardly tapered pit can be shaped e.g. spherical, as a conic of revolution or pyramidal, or can have a truncated shape (a truncated conic of revolution or a truncated pyramid). Sides of this inwardly tapered pit extend or stretch out along the width of said body of semiconductor material. The inwardly tapered pit may have a vertex lying near the body of semiconductor material, whereby the angle between the sides and a line trough the vertex of said inwardly tapered pit is preferably 45° or less. The inwardly tapered pit is preferably positioned at a vertical symmetry axis of the body of semiconductor material. Vertical symmetry of the device can be defined as symmetry around the direction perpendicular to the interface between the supporting substrate and the semiconductor body.

The reflecting surface, e.g. formed by the sides of the inwardly tapered pit, may comprise a stack of at least a conductive layer and an insulating layer.

According to a second embodiment of a device according to the present invention, a second portion of the reflecting element is formed in a package on which the substrate supporting the light emitting device is mounted.

Preferably thermal and/or electrical connections are formed between the body of semiconductor material and the package.

The substrate may form a thermal connection between the body of semiconductor material wherein the light is generated and the stem on which the substrate is pasted, and which is part of the package. The stem acts as a heat sink. A majority of the heat resulting from the generation of radiation is drained trough the substrate to the housing. The substrate may therefore comprise heat conductive materials such as MICA or sapphire.

The first portion of the reflecting element that is formed in the substrate may also thermally connect the semiconductor body with the package. In case of an inwardly tapered pit, the pit can be filled with heat conductive materials, such as e.g. metal, to form a heat conductive path between the body and the housing to assist in the transfer of heat towards the stem.

The substrate may form an electrical connection between the stem, acting as a bottom electrode, and the semiconductor body.

The portion of the reflecting element that is formed in the substrate may electrically connect the semiconductor body with the package for supplying electrical power to said semiconductor body.

The present invention also provides an array of light emitting devices each comprising a body of semiconductor material emitting radiation in a first direction and in at least one additional direction, at least one of said additional directions being opposite the first direction, and a reflecting element, whereby the reflecting element is oriented to the body of semiconductor material such that a majority of radiation emitted by each of the bodies of semiconductor material is said direction opposite the first direction, is redirected to the first direction alongside the bodies of semiconductor material by the reflecting elements.

In a second aspect of the present invention methods are disclosed to manufacture light emitting devices, comprising a body of semiconductor material emitting radiation in a first direction and in at least one additional direction, at least one of the additional directions being opposite said first direction, and a reflecting element, oriented to said body of semiconductor material such that a majority of the radiation emitted by said body of semiconductor material is redirected alongside the body of semiconductor material by said reflecting element to said first direction.

According to a first embodiment, a substrate is provided. In this substrate at least a portion of the reflecting element is formed. The body of semiconductor material is transferred to the surface of the substrate opposite the portion of said reflecting element formed in the substrate. Preferably, the body of semiconductor material is positioned coaxial with said portion of the reflecting element. Then the body of semiconductor material and the supporting substrate may be mounted on a package.

The formation of a portion of the reflecting element in the substrate can further comprise the step of making an inwardly tapered pit in said substrate, whereby the sides of said inwardly tapered pit stretch out along the width of said body of semiconductor material. The inwardly tapered pit in the substrate may be obtained e.g. by drilling a hole in the substrate, by moulding the substrate into the desired shape or by etching.

According to another embodiment, a light emitting device is formed on a substrate, after which a portion of said reflecting element is formed in said substrate, opposite to and preferably coaxially aligned with the semiconductor body. Then the substrate may be mounted on a package. The portion of the reflecting element may be formed in the substrate by making an inwardly tapered pit in the substrate, e.g. by etching or by drilling, whereby the sides of said inwardly tapered pit extend along the width of said body of semiconductor material. Preferably a protective layer is applied on the light emitting device before forming the reflecting element in the body of semiconductor material.

According to a further embodiment of a method for manufacturing a light emitting device according to the present invention, a reflecting element with a focal point is formed. An optical transparent support for a body of semiconductor material is provided, e.g. by filling the reflecting element with optical transparent material up to the focal point level. The body of semiconductor material is then placed substantially in the focal point of the reflecting element, being mechanically supported by the optically transparent support. Preferably, in this case, the body of semiconductor material has dimensions which are small compared to the optical aperture of the light emitting device, the optical aperture being a virtual surface through the radiation emitted from the device perpendicular to the direction of radiation. Preferably the cross-sectional area of the semiconductor body occupies less than 10%, more preferably less than 5%, of the optical aperture.

These and other features and advantages of the present invention will become apparent from the following detailed description, taken in conjunction with the accompanying drawings, which illustrate, by way of example, the principles of the invention. The reference figures quoted below refer to the attached drawings.

### Brief description of the drawings

All drawings are intended to illustrate some aspects and embodiments of the present invention. Devices and fabrication steps are depicted in a simplified way for reason of clarity. Not all alternatives and options are shown and therefore the invention is not limited to the content of the given drawings.

Fig. 1 shows a lens type LED according to the prior art.

Fig. 2 shows a reflection type LED according to the prior art.

Fig. 3 shows a schematic of a high efficiency LED with grating structure according to the prior art, the internal reflection is illustrated.

Fig. 4A is a schematic representation of a side light emitting device according to a first embodiment of the present invention, whereby a reflecting element is formed in a substrate supporting a body of semiconductor material. Fig. 4B is a schematic representation of a side light emitting device according to a second embodiment of the present invention, whereby a first portion of a reflecting element is formed in a substrate supporting a body of semiconductor material, while a second portion of a reflecting element is formed in a package on which the substrate is mounted.

Figs. 5A, 5B and 5C are schematic representations of some shapes of pits in a supporting substrate.

Fig. 6 is a schematic representation of a side light emitting device with a truncated conical or pyramidal pit filled with conductive glue to paste and attach the substrate to a stem.

Fig. 7A is a schematic representation of a reflecting type light emitting device according to an embodiment of the present invention. Fig. 7B is a cross sectional view according to A-A in Fig. 7A.

Figs. 8A to 8F are a schematic representation of a method to manufacture a side light emitting device, according to an embodiment of the invention.

Fig. 9: schematic representation of a method to manufacture a side light emitting device, according to another embodiment of the invention.

Figs. 10 A and 10B are a schematic representation of a method to manufacture a side light emitting device, according to a further embodiment of the invention.

### Description of illustrative embodiments

In relation to the appended drawings the present invention is described in detail in the sequel. It is apparent however that a person skilled in the art can imagine several other equivalent embodiments or other ways of executing the present invention, the spirit and scope of the present invention being limited only by the terms of the appended claims.

In a first aspect of the present invention a light emitting device is disclosed comprising a light emitting body of semiconductor material and a reflecting element that redirects outside the semiconductor body a majority of the emitted light into a single direction.

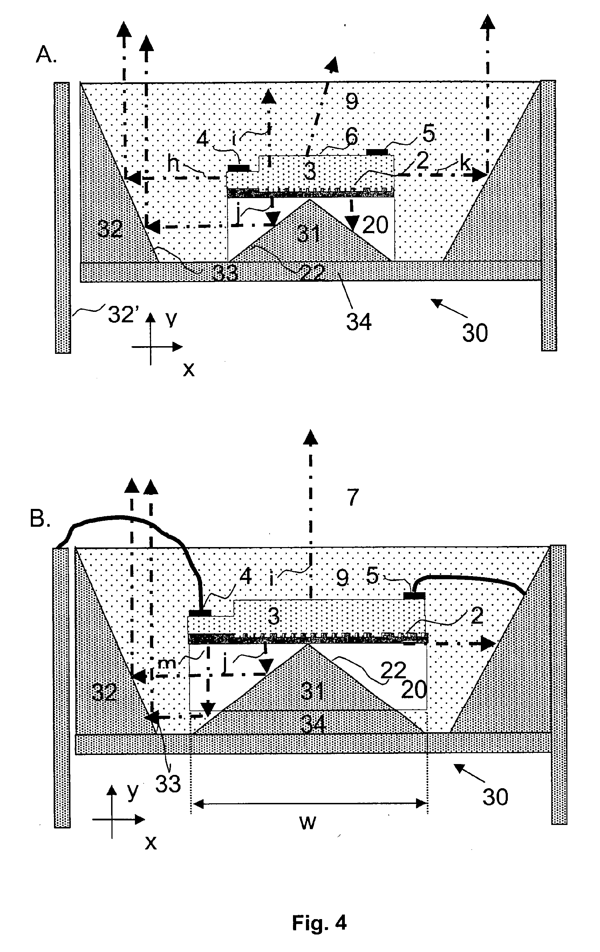

Fig. 4A illustrates a first embodiment of a light emitting device (LED) according to the present invention. The solid-state device comprises a semiconductor film or body 3 of semiconductor material comprising a radiation generating zone, preferably a quantum well or a diode junction. The solid state device can have dimensions of e.g. 300 µm by 300 µm or 2 mm by 2 mm. The semiconductor body 3 can have e.g. a height of 300 nm or less, preferably 200 nm or less. Preferably the light is generated in the active layer of a heterojunction diode, such that the bandgaps of the current confinement layers above and underneath the active layer are larger than this of the active layer as is disclosed e.g. in EP-998701619. In this way, the absorption of photons in these confinement layers is negligible. One of these confinement layers is p-type doped, and injects holes in the active layer under forward diode bias, while the other confinement layer is n-type doped, and injects electrons in the active layer under forward bias. At least one surface 2 of the thin-film semiconductor body 3 is preferably textured to overcome the internal reflection of the light at this surface. Methods for texturing surfaces are disclosed in EP-998701619, which is hereby incorporated by reference. The body 3 of semiconductor material or semiconductor body emits radiation in a first direction i and in at least one additional direction j, k, h. At least one of these additional directions j is in an opposite relation i to this first direction.

Light is emitted from at least two surfaces 2, 6 of the semiconductor body 3 substantially parallel to the plane of the diode junction or quantum well. The plane of a diode junction or of a quantum well can be defined as the plane in which the metallurgical junction is situated. The body 3 of semiconductor material thus radiates at least in two opposite directions i, j from surfaces, which can be labelled as the front surface 6 and back surface 2 of this body 3. The semiconductor body 3 can comprise a stack of semiconductor materials formed on a semiconductor or other suitable substrate 20 as know by a person skilled in the art. According to the present invention, a majority of the light is emitted or outcoupled from the top surface 6 and bottom surface 2 of the semiconductor body 3, contrary to prior art devices, where no light is outcoupled from the bottom surface 2. Some part of the radiation, indicated by arrows h, k, may also be emitted through the lateral surfaces of the semiconductor body 3, depending on the dimensions of the LED.

The semiconductor substrate 20 of the device can be e.g. 100 µm thick (measured in y-direction on Fig. 4A). In the substrate 20 made of e.g. sapphire, a pyramidal pit 31 is formed with a top angle 2β of e.g. 90°. The sides 22 of this pyramid extend along the width of the semiconductor body 3 mounted on top of the substrate 20. Approximately all the light emitted by the back surface 2 of the semiconductor body 3 will have an incidence on these sides 22. The stack of solid-state diode and substrate 20 is mounted in a commercially available package.

Two electrode pads 4, 5 are provided to contact both sides of the p-n junction. Preferably means are provided to prevent light generation under the electrode area, because light generated under the electrode area suffers more parasitic absorption from the contact. These means can be an oxidised Al containing layer or a proton-implanted region.

A reflecting element 30 is oriented to the body 3 of semiconductor material such that a majority of the radiation, emitted by this semiconductor body 3 in a direction j opposite to the first direction i, is redirected alongside said body 3 of semiconductor material by the reflecting element 30 to the first direction i. The shape and the position of the reflecting element 30 with respect to the semiconductor body 3 are chosen such that a majority of the radiation emitted in a direction j opposite the first direction after reflection bypasses the semiconductor body 3 to the first direction i. With a majority of radiation is meant that at least 50%, preferably 60%, more preferably 80% of the light radiated from a surface 2 of the semiconductor body 3 in a direction is redirected around the semiconductor body 3 to a first direction i, which may be the opposite direction. Whereas the semiconductor body 3 itself radiates in more than one direction, the light emitting device provides a light beam in a single direction i. The light emitted from the surfaces of the semiconductor body 3 can be redirected by this reflecting element 30 in a substantially single direction I without passing trough the semiconductor body 3. The reflecting element 30 reflects a major portion of the light around the semiconductor body 3 into a light beam, preferably a parallel beam of light.

According to an embodiment of the invention a light emitting device is disclosed, wherein the substrate 20, on which the semiconductor body 3 is grown or to which it is attached, is shaped and adapted such as to reflect the light emitted from the bottom surface 2 of the LED and to assist in redirecting this light to the front side of the device alongside the semiconductor body 3. As explained above the number of passes of the light trough the semiconductor body 3 has to be minimised if one wants to decrease the absorption of the light. The emission of light at every incidence at a surface must be promoted. At least a portion of the reflecting element 30 is formed in the substrate 20 supporting the body 3 of semiconductor material. The substrate 20 must be optically transparent for the emitted radiation and must essentially not absorb the incoming radiation. The original bulk or substrate on which semiconductor layers are formed to create a light emitting diode can be replaced by a transparent substrate, that also doesn't absorb the photons generated in the active layer. This second substrate can be cheaper or easier to process. The semiconductor body 3 is transferred from its original or first substrate to this second substrate or carrier. The process of release from the growth substrate, transfer to and bonding on the final substrate of the semiconductor film can be achieved with technologies such as epitaxial lift-off followed by Van-der-Waals bonding to the host substrate, by glueing with glue or epoxy or wafer bonding. Such transparent substrates can be wafers, foils, or sheets of glass, polyimide, plastic, or other transparent substrates. It also includes thermally conductive transparent materials such as MICA or sapphire.

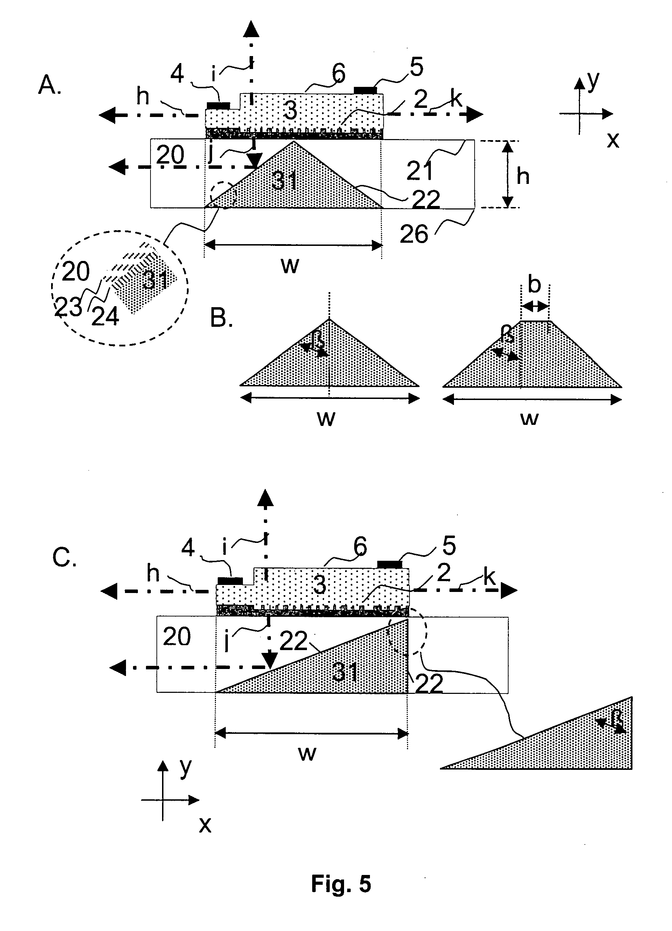

An adapted substrate as represented in Fig. 5A can comprise a pit 31, a cavity or a groove present in a surface 26 of the substrate 20 opposite a surface 21 on which the semiconductor body 3 is present. The vertex of the pit 31 lies near the body 3 of semiconductor material. Preferably the sides 22 of the pit 31 extend along the width W of the body 3 of semiconductor material such that the ground plane of the pit 31, i.e. the intersection of the pit 31 and the surface of the substrate 20, encloses the perimeter of the contact area 2 between the semiconductor body 3 and the supporting substrate 20. In case of very large devices this might result in very thick substrates 20 being needed, as the height h of the substrate 20 is related to the width w of the semiconductor body 3 and the orientation β of the side. Typically the height of a substrate 20 on which a semiconductor body 3 is formed or placed, ranges from 100 µm to 700 µm, and typically is between 250 µm and 500 µm. The sides of this pit 31 will form a reflecting surface, redirecting the incident radiation originating from the back surface 2 of the semiconductor body 3. Preferably a stack of at least one dielectric layer 23 and at least one conductive layer 24 is formed on top of this reflecting surface 22 to improve the reflecting properties of this reflecting surface (see Fig. 5A, enlarged view). The insulating layer 23 can be e.g. an oxide or nitride layer. The conductive layer 24 can be e.g. a metal, such as aluminium, copper or alloys thereof. Light emitted towards this adapted substrate 20 provided with a pit 31 will be reflected in a direction substantially perpendicular to the direction of incidence on the substrate 20, depending on the angle or orientation of the sides 22 of the pit 31. The orientation of the sides 22, and thus the angle β between a line according to the direction of the height h of the substrate 20 and the sides 22 may vary in function of the width w of the pit 31, compared to the height h of the substrate 20, and in function of the pit 31 being truncated or not, as represented in Fig. 5B.

Preferably the pit 31 is positioned at the vertical symmetry axis of the body 3 of semiconductor material. Preferably this pit 31 has a spherical, a pyramidal or a truncated pyramidal shape, or is shaped as a conic of revolution or a truncated conic of revolution. The angle β between the sides 22 and a line trough the vertex of the conic of revolution is preferably around 45° or less.

The pit 31 can be asymmetrically positioned with respect to the semiconductor body 3. The sides 22 of the pit 31, which still stretch out along the width w of the semiconductor body 3, are now oriented at different angles. In an extreme case the vertex of the pit 31 can be located at the edge of the semiconductor body 3, as shown in Fig. 5C.

According to a preferred embodiment of the invention, a light emitting device is disclosed, wherein a housing 32, on which the semiconductor body 3 is mounted, is shaped and adapted to reflect the light emitted from the bottom surface 2 of the LED and to assist in redirecting this emitted light to the front side the device alongside the solid-state diode. A second portion 32 of the reflecting element 30 is hence formed in a package on which the substrate 20 supporting said light emitting device is mounted.

This embodiment is illustrated in Figs. 4A and 4B. Light emitted in a direction j opposite a first direction i, towards the adapted substrate 20, is reflected at the sides 22 of the pit 31 in a direction substantially perpendicular to the direction of incidence on the substrate 20. This reflected light is reflected a second time, at the surface 33 of the uprising parts of the package 32, towards the front of the device in a direction i substantially parallel to and opposite to the initial direction of this portion of the emitted light. These housings 32, illustrated in Fig. 4, but also shown in the prior art device of Fig. 1, are known to a person skilled in the art and are commercially available. To avoid the use of thick substrates 20 in case of large semiconductor bodies 3 or dies, the stem 34 on which the substrate 20 is pasted and which forms part of the package, can be adapted to downwardly extend the sides 22 of the pit 31 until a reflecting surface 30 is obtained that does extend along the width w of the semiconductor body 3, as shown in Fig. 4B. As indicated on Figs. 4A and 4B, the cavity of the package in which the device is mounted is filled with an optical transparent material 9 to seal the device. The filling of this cavity can be done in one step in case of the embodiment of Fig. 4A, where the filling may be done after the semiconductor body 3 and the substrate 20 are placed in the package, or on in a more then one step in case of the embodiment of Fig. 4B, where the filling is done partly before the semiconductor body 3 and the substrate 20 are placed in the package, in order to fill underneath it, and partly after the placement of semiconductor body 3 and substrate 20.

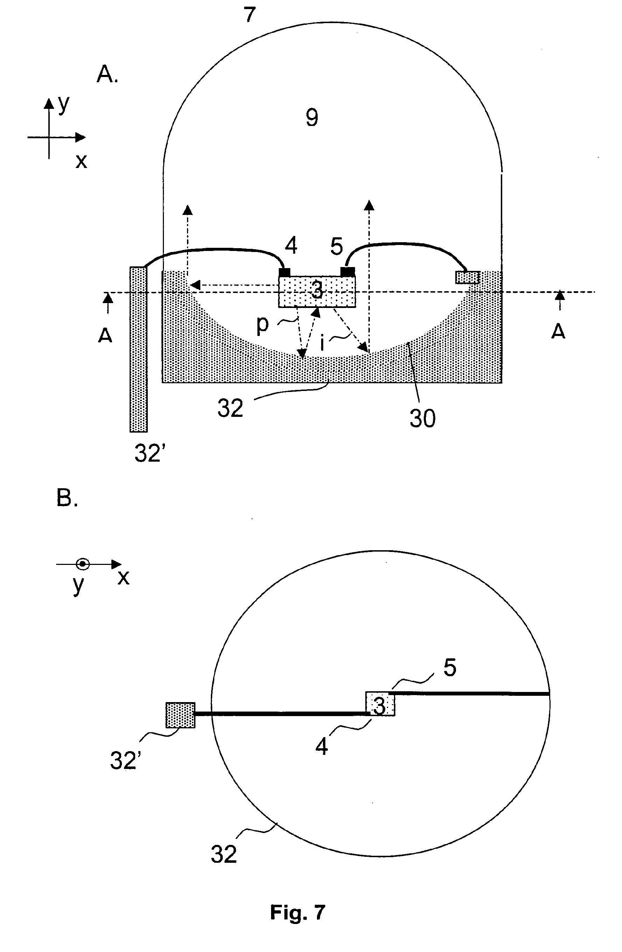

According to a further embodiment of the invention the substrate 20 supporting the semiconductor body 3 forms a thermal connection between the semiconductor body 3 and the stem 34. This thermal connection can drain a majority of heat generated in the body 3 of semiconductor material to the package, serving as a heat sink. The substrate 20 can comprise heat conductive materials for draining this majority of heat. The substrate 20 can be made from thermally conductive transparent materials such as MICA or sapphire. In case the pit 31 formed in the substrate 20 has a truncated shape, as represented in Fig. 6, the pit 31 can be filled with a metal that serves two purposes. It is part of the conductive layer of the reflecting surface 30 and it forms a thermal connection between the semiconductor body 3 and the stem 34. The truncated pit 31 can also be filled with a thermoconductive glue used to paste and attach the substrate 20 to the stem 34. The truncated pit 31 will have a top surface in contact with the semiconductor body 3. The heat transport trough the truncated pit 31 will also depend on the size b (Fig. 5B) of this top surface. An optimal heat transport from the semiconductor body 3 towards the stem 34 can be obtained by varying the contact areas b between substrate 20 and truncated pit 31 on the one hand, and the semiconductor body 3 on the other hand, and by varying the thermoconductive materials used for the substrate 20 or truncated pit 31.

According to another embodiment of the invention the substrate 20 supporting the semiconductor body 3 forms an electrical connection between the semiconductor body 3 and the stem 34. The substrate 20 can comprise conductive materials or can be of a semiconductor material. In case the pit 31, formed in the substrate 20, has a truncated shape, the pit 31 can be filled with a metal that serves two purposes, namely being part of the conductive layer of the reflecting surface and forming an electrical connection between the semiconductor body 3 and the stem 34. The truncated pit 31 can also be filled with a conductive glue 35 used to paste and attach the substrate to the stem 34, as represented in Fig. 6.

A lead assembly for supplying electric power to a light emitting element or device normally comprises two electrode pads 4, 5, as shown in Figs. 4A and 4B, e.g. to contact both sides of a p-n junction. These electrode pads 4, 5 can impede the light propagation, e.g. light radiated towards the front or top of the light emitting device can be reflected by the contact pads or by the contact wires if contact is made to the top surface of the device, which leads to a decreased external efficiency. If one of these electrode pads is formed by the substrate 20 connecting the backside of the light emitting element, only one lead assembly or contact pad 4 and contact wire is necessary to contact the front side or other side of e.g. the p-n junction, as shown in Fig. 6. If, as explained in a previous embodiment, the majority of the heat generated in the semiconductor body 3 is drained trough the substrate 20 or pit 31, the dimensions of this contact wire can be minimised to only conduct electrical current to the device.

According to a further embodiment of the invention, described in Fig. 7, a light emitting device comprising a semiconductor body 3 and a reflecting element 30 is disclosed, wherein the dimensions of the semiconductor body 3 are small compared to the optical surface of the device. The semiconductor body 3 and/or the substrate 20 is not in direct contact with the housing 32 as was the case in previous embodiments. The reflecting element 30 can be a spherical or parabolic shaped reflector and the semiconductor body 3 is positioned substantially in the focal point of the reflector 30. The semiconductor body 3 is only electrically contacted at the contact pads 4, 5 by a lead assembly, preferably thin metal, e.g. copper or aluminium wires, which provide electrical power to the device from the input pins 32, 32'. The diameter of such wires is sufficient to allow the desired current density towards the device, but is not sufficient to transfer a major portion of the heat or to mechanically support the semiconductor body 3. The contact pads 4, 5 are limited in area so that only a minor fraction of the surface of the semiconductor body 3 is covered with metal. Preferably the area occupied by the contact pads 4, 5 is less then 10% of the overall surface area of the semiconductor body 3. Typical contact size of a contact pad 4, 5 is 100 µm x 100 µm. A majority or at least a major portion of the surface of the semiconductor body 3 can hence emit radiation towards the outside world 7. The semiconductor body 3 is embedded in an optical transparent material 9, preferably heat conductive so as to transfer heat from the body 3 towards the package 32 or heat sink. This optical transparent material 9 or resin can mechanically support the semiconductor body 3. The material 9 can be provided in a two step process having in first step the cavity filled up to approximately the focal point of the reflector 30 at which level the semiconductor element can be placed or inserted. After connecting the semiconductor element by forming the lead assembly, the further filling and formation of a lens cap or dome by the optical material 9 can proceed. The optical surface of the device is defined as the surface at which the semiconductor body 3 is located. If the cross-sectional area of the semiconductor body 3 is small compared to the area of the optical surface, only a minor amount of the light reflected by the reflecting element 30 will propagate trough the semiconductor body 3. Fig. 7B gives such a cross-sectional view. Preferably the cross-sectional area of the semiconductor body 3 occupies 10% or less, preferably 5% or less, of the optical aperture of the light emitting device. A typical example is a concave shaped reflector having a diameter of 10 mm in which a semiconductor device of 300 µm x 300 µm is placed at the focal point of the reflector 30. In this example only about 0.1% of the optical aperture is covered by the semiconductor device. Typical package sizes range from 2 to 5 mm or even larger. Although a device according to this embodiment shows an improved external efficiency, the corresponding manufacturing methods are more complex due to the e.g. the two step filling process.

The present invention also discloses methods to manufacture a light emitting device, comprising a light emitting body of semiconductor material and a reflecting element that redirects outside the semiconductor body a majority of the emitted light into a single direction.

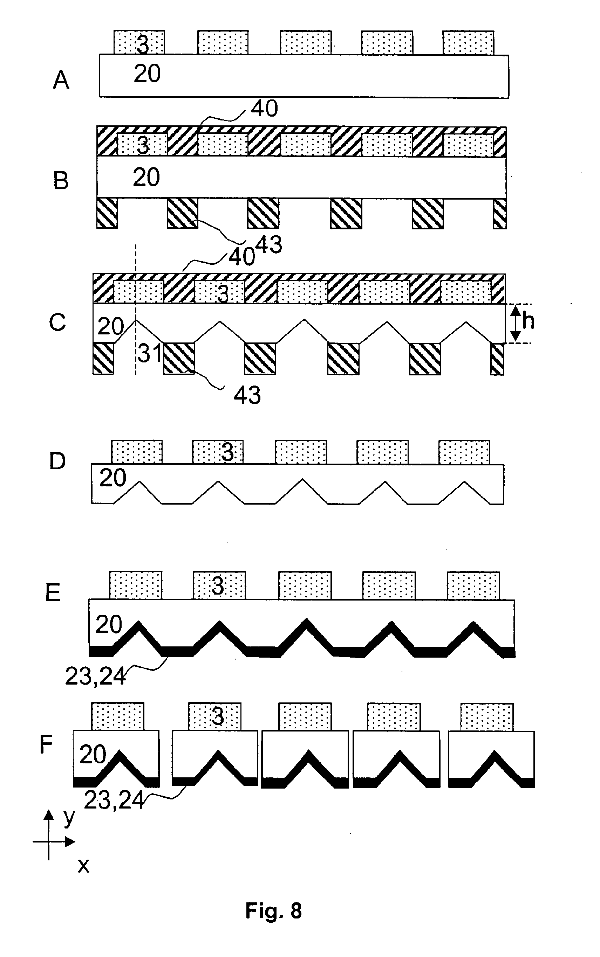

According to an embodiment of the invention, a method of producing a light emitting device with reflecting element is described with reference to Figs. 8A to 8F. After forming or placing a solid-state device 3 or an array of solid state devices 3 on an optical transparent substrate 20 (Fig. 8A), the devices 3 are covered with a protective layer 40. This protective layer 40 can be e.g. a resin layer or a wax layer. On the backside of the substrate 20, a pattern is defined (Fig. 7B). The process of defining this pattern can comprise the steps of depositing a photosensitive layer 43 and illuminating this layer 43 trough a mask. This mask can be the inverse of the mask used to define the solid-state devices 3. The openings in the photosensitive layer 43 are positioned with respect to the devices 3 and are aligned coaxially with these devices 3. Some misalignment may however be tolerable. The next step is to etch the pits 31 using this photosensitive layer as a mask. This etch can e.g. be an anisotropic wet etch as disclosed in US-4080245. The time span of the etching depends on the composition and temperature of the wet etchant, but also on the thickness of the transparent substrate 20. As indicated on Fig. 8C, the pit 31 doesn't need to extend over the whole height h of the substrate 20. After the wet etch the patterned photosensitive layer 43 and the protective layer 40 are removed, as shown in Fig. 8D. The backside of the wafer is covered with reflective stack 23, 24 (Fig. 8E). Finally the wafer is singulated, as shown in Fig. 8F. A singulated device is mounted into a commercially available package using an adhesive. This adhesive can be thermo-conductive and will conduct heat generated by the LED to the heat sink 32.

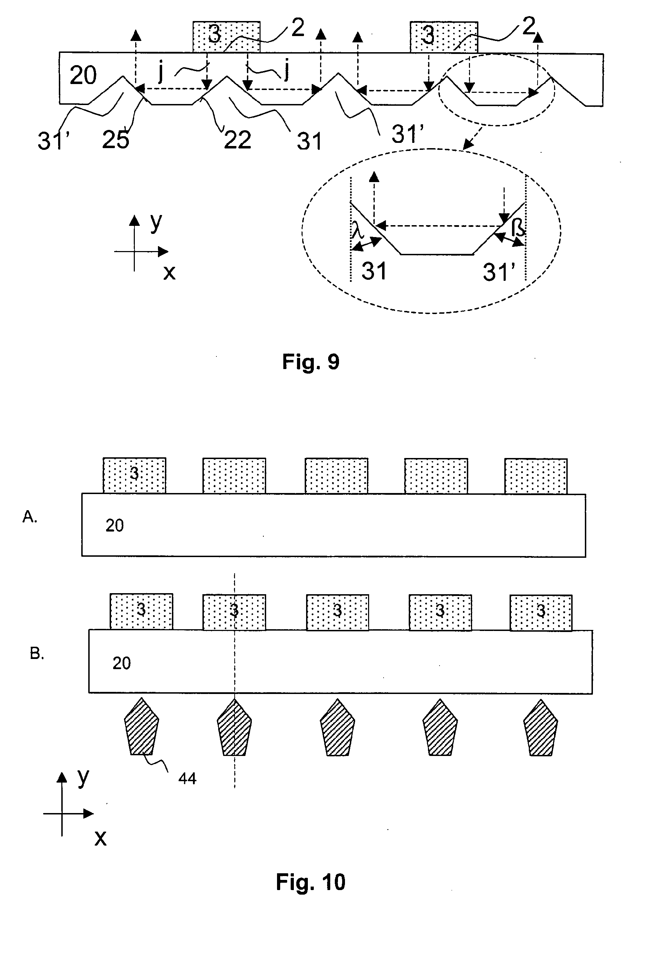

The dies don't need to be singulated, but be can be grouped to form an optical array as shown in figure 9. In this figure additional neighbouring or dummy pits 31' are formed around a first pit 31. The spacing between the first pit 31 and the additional pits 31' can be varied, but should preferably be as small as possible to save area and limit the size of the package in which this array can be mounted. Whereas a first pit 31 in the centre and aligned to the solid-state device reflects the light j emitted by the back surface 2 of the semiconductor body 3 in a substantially perpendicular direction, the neighbouring pits 31' reflect this reflected light towards the top of the device as indicated by the dashed arrows in Fig. 9. Fig. 9 illustrates the case in which the pit is shaped as a cone of revolution. Between the angle β of a side 22 of a first pit 31 and an angle λ of a side 25 of a neighbouring pit 31', a relationship exits to result in a reflection substantially perpendicular with the direction of incidence. This relationship can be determined from the laws of geometrical optics. If angle β is smaller or equal to 45 ° then λ should be (90°- (β/2)).

In another embodiment of the invention the step of forming a portion of the reflecting element in a substrate comprises the step of defining a pit in the supporting substrate 20 by using a drilling machine with at least one drilling head 44, as represented in Fig. 10B. The shape of the drilling heads 44 is adapted to obtain the desired shape of the reflecting surface. The front surface of the substrate 20 can be covered with a protective layer during this drilling step. The drilling can be done once the semiconductor devices are formed in the semiconductor layers deposited on the substrate 20. The semiconductor devices can as well be formed in the semiconductor layers deposited on the supporting substrate 20 after the formation of the pits 31. This sequence can be beneficial to ensure lithographically controlled alignment of the solid-state devices to the pits in the optical transparent substrate 20. No transfer of the semiconductor device from its original substrate to a supporting substrate is necessary in this embodiment.

According to another embodiment of the invention the step of forming a portion of the reflecting element 31 in a substrate 20 comprises the step of forming a pre-shaped substrate by moulding or moulding and sintering the substrate into the desired shape. The semiconductor devices can be processed on a first or original, e.g. semiconductor, substrate and are then afterwards transferred to this pre-shaped transparent substrate comprising the pits with the desired shape so as to obtain the required reflecting surfaces.

## Claims

1. A light emitting semiconductor device,
comprising
a body (3) of semiconductor material emitting radiation in a first direction (i) and in at least one additional direction (h, j, k), at least one (j) of said additional directions being opposite said first direction (i);
and
a reflecting element (30)
**characterised in that**
said reflecting element (30) is oriented to said body (3) of semiconductor material such that a majority of the radiation emitted by said body (3) of semiconductor material in said opposite direction (j) is redirected alongside said body (3) of semiconductor material by said reflecting element (30) to said first direction (i).

2. A device as recited in claim 1 wherein at least a first portion of said reflecting element (30) is formed in an optical transparent substrate (20) supporting said body (3) of semiconductor material.

3. A device as recited in claim 2 wherein a second portion of said reflecting element (30) is formed in a package (32) on which said substrate (20) supporting said light emitting device is mounted.

4. A device as recited in claim 2 or 3 wherein said substrate (20) comprises an inwardly tapering pit (31) for forming a reflecting surface, sides (22) of said inwardly tapering pit (31) extending along the width (w) of said body (3) of semiconductor material.

5. A device as recited in claim 4, whereby the pit (31) has a vertex lying near said body (3) of semiconductor material.

6. A device as recited in claim 5, wherein the angle between sides (22) and a line trough the vertex of pit (31) is 45° or less.

7. A device as recited in any of claims 4 to 6, whereby said inwardly tapering pit (31) is positioned at a vertical symmetry axis of said body (3) of semiconductor material.

8. A device as recited in any of claims 4 to 7, wherein said inwardly tapering pit (31) has a spherical, a conic of revolution, or a pyramidal shape or has a shape which is a truncation of any of these shapes.

9. A device as recited in any of claims 2 to 8, wherein said substrate (20) thermally connects said body (3) of semiconductor material with a package (32) for draining a majority of heat generated by said body (3) of semiconductor material to said package (32).

10. A device as recited in claim 9, wherein said substrate (20) comprises heat conductive materials for draining said majority of heat.

11. A device as recited in claim 10 wherein said heat conductive material is MICA or sapphire.

12. A device as recited in any of claims 2 to 11, wherein said first portion of said reflecting element (30) formed in said substrate (20) thermally connects said body (3) of semiconductor material with said package (32) for draining a majority of heat generated by said body (3) of semiconductor material to said package (32).

13. A device as recited in claim 12, wherein said first portion of said reflecting element comprises heat conductive materials for draining said majority of heat.

14. A device as recited in claim 13, wherein said heat conductive material is a metal.

15. A device as recited in any of claims 2 to 14, wherein said substrate (20) electrically connects said body (3) of semiconductor material with said package (32) for supplying electrical power to said body (3) of semiconductor material.

16. A device as recited in any of claims 2 to 15 wherein said first portion of said reflecting element formed in the substrate (20) electrically connects said body (3) of semiconductor material with said package (32) for supplying electrical power to said body (3) of semiconductor material.

17. A device as recited in any of claims 1 to 16, wherein said reflecting element (30) comprises a stack of at least a conductive layer and an insulating layer.

18. An array comprising one or more devices as recited in any of claims 1 to 17.

19. A method for manufacturing a light emitting device,
comprising a body (3) of semiconductor material emitting radiation in a first direction (i) and in at least one additional direction, of which at least one of said additional directions is opposite (j) said first direction and a reflecting element (30), oriented to said body (3) of semiconductor material such that a majority of the radiation emitted by said body (3) of semiconductor material is redirected alongside said body (3) of semiconductor material by said reflecting element (30) to said first direction (i),
comprising the steps of
providing a substrate (20),
forming a portion of said reflecting element (30) in said substrate (20), and thereafter transferring said body (3) of semiconductor material to a surface of said substrate (20) opposite said portion of said reflecting element (30) in said substrate (20).

20. A method for manufacturing a light emitting device,
comprising a body (3) of semiconductor material emitting radiation in a first (i) and in at least one additional direction, of which at least one (j) of said additional directions is opposite said first direction (i) and a reflecting element (30), oriented to said body (3) of semiconductor material such that a majority of the radiation emitted by said body (3) of semiconductor material is redirected alongside said body (3) of semiconductor material by said reflecting element (30) to said first direction (i),
comprising the steps of
providing a substrate (20) with a front surface and a back surface being on opposite sides,
forming or placing a light emitting device on the front surface of the substrate (20), and
thereafter forming a portion of said reflecting element in the back surface of said substrate (20).

21. A method as recited in any of claims 19 or 20, wherein the step of forming a portion of said reflecting element in said substrate further comprises the steps of:
making an inwardly tapered pit (31) in said substrate (20), whereby sides (22) of said inwardly tapered pit (31) extend along the width (w) of said body (3) of semiconductor material.

22. A method as recited in claim 20, whereby the inwardly tapering pit (31) is made by drilling, by pre-moulding the substrate (20) with a pit in it, or by etching.

23. A method ad recited in claim 22, whereby a protective layer is applied to the light emitting device before etching.

24. A method according to any of claims 19 to 23, furthermore comprising the step of mounting the substrate (20) on a package (32).
